# EUROPEAN PATENT APPLICATION

(11) **EP 2 427 034 A1**
(43) Date of publication of application: **07.03.2012**
(21) Application number: 10175159.2
(22) Date of filing: 03.09.2010
(51) Int. Cl.: H05K 1/02, H05K 1/18, H05K 11/00, H01B 7/00, F21V 15/00

(54) **Anti-deflection structure for flexible circuit board**

(71) Applicant: Long Jing International Technology Enterprise Co., Ltd., Yongkang City (TW)
(72) Inventor: Lee, Hao-An, Yongkang City (TW)
(74) Representative: Viering, Jentschura & Partner

(57) **Abstract**

An anti-deflection structure for a flexible circuit board includes a flexible circuit board (1), at least one electronic element (2), and at least one anti-deflection element (3). The electronic element (2) and the anti-deflection element (3) are disposed on the flexible circuit board (1). The electronic element (2) provides a weld (21) for being soldering to the flexible circuit board (1). The anti-deflection element (3) is arranged around the weld (21) of the electronic element (2). By means of the anti-deflection element (3) absorbing an external force in time of bending the flexible circuit board (1), the external force is not directly imparted upon the weld (21). Therefore, the weld (21) does not deviate from the flexible circuit board (1) easily, and the electronic element (2) does not depart from the flexible circuit board (1), either.

## Description

### BACKGROUND OF THE INVENTION

### 1. Field of the Invention

The present invention relates to an anti-deflection structure for a flexible circuit board that utilizes anti-deflection elements disposed around electronic elements to provide protection and prevention on a weld between the electronic element and the flexible circuit board from breakage when the weld bears an external force and thence bends.

### 2. Description of the Related Art

Generally, a car provides lamps on the car body or on other products correlated to the car body. Except providing a satisfactory appearance on the car body, the lamp also offers the brightness. Herein, the lamp usually adopts electronic elements to serve the illumination. Such electronic element like an LED is usually adopted. However, a weld between the electronic element and a circuit board might be adversely broken in view of the bending of the lamp in accordance with the arc of the car body. As a result, the electronic element falls off the circuit board, which incurs a lack of an electronic element on the lamp.

In fact, if the weld between the electronic element and the circuit board could prevent from being directly forced by the external force, the electronic element might not fall off the lamp.

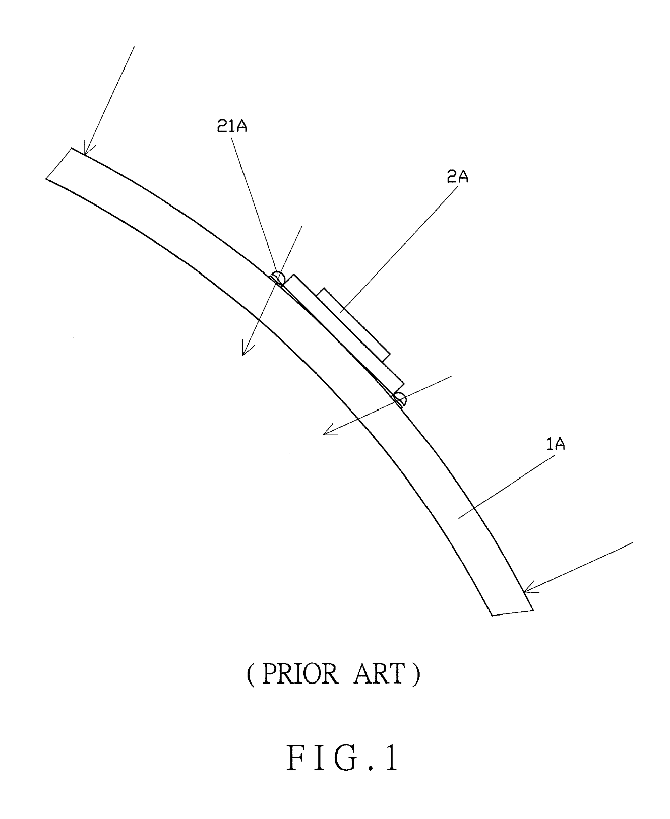

A conventional structure is shown in Fig. 1. An electronic element 2A is installed on a flexible circuit board 1A. A weld 21A is disposed for connecting the electronic element 2A with the flexible circuit board 1A. Imparting an external force on the flexible circuit board 1A allows the flexible circuit board 1A and the weld 21A soldered on the flexible circuit board 1A to be accordingly bent. Unfavorably, if the weld 21A is often imparted by a large external force, the weld 21A facilely breaks, and the electronic element 2A readily falls off the flexible circuit board 1A. As a result, the electronic element 2A is unable to function well.

Taiwan Patent No. M379006 discloses an LED lamp comprising a first guiding wire, a second guiding wire arranged adjacent to the first guiding wire at intervals, an isolating body, at least one LED, and a fixing frame disposed to a correspondent position of the LED. The isolating body has an upper surface and a lower surface that are respectively covered on the first guiding wire and the second guiding wire. A hollow slot is defined on the upper surface for forming an exposed first connecting section on the first guiding wire and forming an exposed second connecting section on the second guiding wire. A conducting manner and a fixing means of the LED lamp could be simplified by connecting a first electrode and a second electrode to the first connecting section and the second connecting section as well as by fixing the fixing frame to the position of the LED.

Herein, above-mentioned invention could be merely applied to the LED lamps since no anti-deflection element is disclosed for absorbing an external force imparted on the LED. Unfortunately, the LED still falls off easily after being bent.

Obviously, the fixing frame could simply limit the contact and the conduction between the LED and the first guiding wire or the second guiding wire. Namely, the problems that the LED readily departs from the circuit board after bending and such construction adversely incurs an inferior contact are still remained to be solved. Nonetheless, the conventional mechanism facilely malfunctions.

### SUMMARY OF THE INVENTION

In order to solve the problem that the conventional electronic element easily deviates in view of the bending from an external force, the present invention provides an anti-deflection structure for a flexible circuit board. The flexible circuit boar installs at least one electronic element with a weld that is soldered to the flexible circuit board. Wherein, the flexible circuit board includes at least one anti-deflection element disposed thereon. The anti-deflection element is further disposed around the weld of the electronic element.

The anti-deflection element adopts a copper foil coated with tin.

The electronic element has a first side and a second side that are respectively disposed thereon as well as correspondingly spaced at intervals; the electronic element further has a third side and a fourth side that are respectively disposed adjacent to the first side and the second side as well as correspondingly spaced at intervals; the anti-deflection element is disposed out of the first side or the second side of the electronic element; the anti-deflection element provides two end portions that are correspondingly disposed as well as spaced at intervals; a distance between the two end portions of the anti-deflection element is larger or equal to a distance between the third side and the fourth side of the electronic element.

The electronic element has a first side and a second side that are respectively disposed at intervals; the electronic element further has a third side and a fourth side that are respectively disposed adjacent to the first side and the second side at intervals; the anti-deflection element provides a first perpendicular section and a second perpendicular section that are mutually parallel to each other as well as are spaced at intervals; the anti-deflection element further provides a horizontal section that is horizontally connected to the first perpendicular section and the second perpendicular section; the first perpendicular section and the second perpendicular section respectively have a first end portion and a second end portion that are opposite to each other and spaced at intervals; the first end portion of the first perpendicular section and the second end portion of the second perpendicular section are respectively disposed out of the third side and the fourth side of the electronic element.

The electronic element has a first side and a second side that are respectively and correspondingly disposed at intervals; the electronic element further has a third side and a fourth side that are respectively disposed adjacent to the first side and the second side at intervals; two opposing anti-deflection elements are disposed around the electronic element; the anti-deflection element provides a first horizontal section and a second horizontal section that are correspondingly and parallelly disposed at intervals; the anti-deflection element further provides a perpendicular section that is connected to the first horizontal section and the second horizontal section; each anti-deflection element installs two end portions that are correspondingly disposed at intervals; the end portions of one anti-deflection element are situated out of the third side of the electronic element; the other anti-deflection is situated with respect to the anti-deflection element; the end portions of the other anti-deflection element are situated out of the fourth side of the electronic element.

At least one surface-mount device (SMD) is disposed on the flexible circuit board, adjacent to the electronic element.

The anti-deflection element has a reflecting surface.

An anti-deflection structure for a flexible circuit board comprises a flexible circuit board, at least one anti-deflection element that is disposed on the flexible circuit board and at least one electronic element that is disposed on the anti-deflection element. The electronic element is electrically connected to the anti-deflection element. The electronic element has a weld that is soldered to the anti-deflection element.

The anti-deflection element adopts a copper foil coated with tin.

The electronic element has a first side and a second side that are respectively and correspondingly disposed thereon at intervals; the electronic element further has a third side and a fourth side that are respectively and correspondingly disposed adjacent to the first side and the second side at intervals; two opposing anti-deflection elements are disposed around the electronic element; the anti-deflection elements have a first horizontal section and a second horizontal section that are correspondingly and parallelly disposed at intervals; the anti-deflection elements further have a perpendicular section that is perpendicularly connected to the first horizontal section and the second horizontal section; each anti-deflection element provides with two end portions that are correspondingly disposed at intervals; the end portions of one anti-deflection element is situated out of the first side and the second side of the electronic element; the other anti-deflection element is situated corresponding to the anti-deflection element; the end portions of the other anti-deflection element are situated out of the first side and the second side of the electronic element; the end portions of the anti-deflection elements provide at least one pointed end.

The electronic element respectively has a first side and a second side that are correspondingly disposed at intervals; the electronic element further has a third side and a fourth side that are respectively disposed adjacent to the first side and the second side at intervals; the anti-deflection element provides a horizontal section and a perpendicular section having one end connected to the first horizontal section; the perpendicular section has an end portion that is positioned out of the second side of the electronic element; the other anti-deflection element is disposed corresponding to the former anti-deflection element; the other anti-deflection element provides a horizontal section and a perpendicular section having one end connected to the horizontal section; the horizontal section includes an end portion that is positioned out of the second side of the electronic element; one of the end portions of the anti-deflection elements has at least one pointed end.

The electronic element has a first side and a second side that are respectively and correspondingly disposed at intervals; the electronic element further has a third side and a fourth side that are respectively disposed adjacent to the first side and the second side at intervals; the anti-deflection element provides a first perpendicular section and a second perpendicular section that are correspondingly and parallelly disposed at intervals; the first perpendicular section and the second perpendicular section have their ends connected to a horizontal section; the first perpendicular section and the perpendicular section correspondingly provide a first end portion and a second end portion that are spaced at intervals; the other anti-deflection element correspondingly provides a perpendicular section and a second perpendicular section that are parallelly disposed at intervals; the first perpendicular section and the second perpendicular section have their ends connected to a horizontal section; the first perpendicular section and the second perpendicular section correspondingly provide a first end portion and a second end portion that are spaced at intervals; the anti-deflection element is disposed around the electronic element; the first end portion and the second end portion of the anti-deflection elements provide at least one pointed end.

The electronic element has a first side and a second side that are respectively disposed as well as correspondingly spaced at intervals; the electronic element further has a third side and a fourth side that are respectively disposed adjacent to the first side and the second side at intervals; the anti-deflection element provides a horizontal section and a perpendicular section having one end connected to the horizontal section; the horizontal section has an end portion that is positioned out of the first side of the electronic element; the other anti-deflection element is disposed corresponding to the former anti-deflection element; the anti-deflection element provides a horizontal section and a perpendicular section having one end connected to the horizontal section; the horizontal section includes an end portion that is positioned out of the first side of the electronic element; one of the end portions of the anti-deflection element has at least one pointed end.

At least one surface-mount device (SMD) is disposed on the flexible circuit board, adjacent to the electronic element.

The anti-deflection element has a reflecting surface.

Advantages of the present invention are as follows:
1. The anti-deflection element disposed around the electronic element absorbs the external force that bends the flexible circuit board, so that the electronic element could be prevented from damage.
2. The anti-deflection element prevents the weld of the electronic element on the flexible circuit board from breakage in time of bending the flexible circuit board.
3. The reflecting surface on the anti-deflection element preferably reflects the light emitted from the electronic element if the electronic element adopts an LED. Thereby, such structure favorably enhances the illumination.
4. The electronic element is soldered to the anti-deflection element, and one end of the anti-deflection element has at least one pointed end. Thereby, the pointed end preferably discharges electricity, and the electronic element could be prevented from the surge energy created by the overloaded current.

### BRIEF DESCRIPTION OF THE DRAWINGS

- Fig. **1**: is a schematic view showing a weld of a conventional electronic element bearing an external force in time of bending;
- Fig. **2**: is an exploded view showing a first preferred embodiment of the present invention;
- Fig. **3**: is a partial enlarged view showing the first preferred embodiment of the present invention;
- Fig. **4**: is a cross-sectional view showing the first preferred embodiment of the present invention;
- Fig. **5**: is a schematic view showing an anti-deflection element being situated out of a first side of the present invention;
- Fig. **6**: is a schematic view showing the anti-deflection element absorbing the external force in time of bending;
- Fig. **7**: is a schematic view showing the first preferred embodiment in using;
- Fig. **8**: is a perspective view showing a second preferred embodiment of the present invention;
- Fig. **9**: is a perspective view showing a third preferred embodiment of the present invention;
- Fig. **10**: is a perspective view showing a fourth preferred embodiment of the present invention;
- Fig. **11**: is a perspective view showing a fifth preferred embodiment of the present invention;
- Fig. **12**: is a perspective view showing a sixth preferred embodiment of the present invention;
- Fig. **13**: is a perspective view showing a seventh preferred embodiment of the present invention;
- Fig. **14**: is a schematic view showing an eighth preferred embodiment of the present invention;
- Fig. **15**: is a schematic view showing a ninth preferred embodiment of the present invention;
- Fig. **16**: is a schematic view showing a tenth preferred embodiment of the present invention;
- Fig. **17**: is a schematic view showing an eleventh preferred embodiment of the present invention; and
- Fig. **18**: is a schematic view showing a twelfth preferred embodiment that the anti-deflection element provides a reflecting surface.

### DETAILED DESCRIPTION OF THE PREFERRED EMBODIMENTS

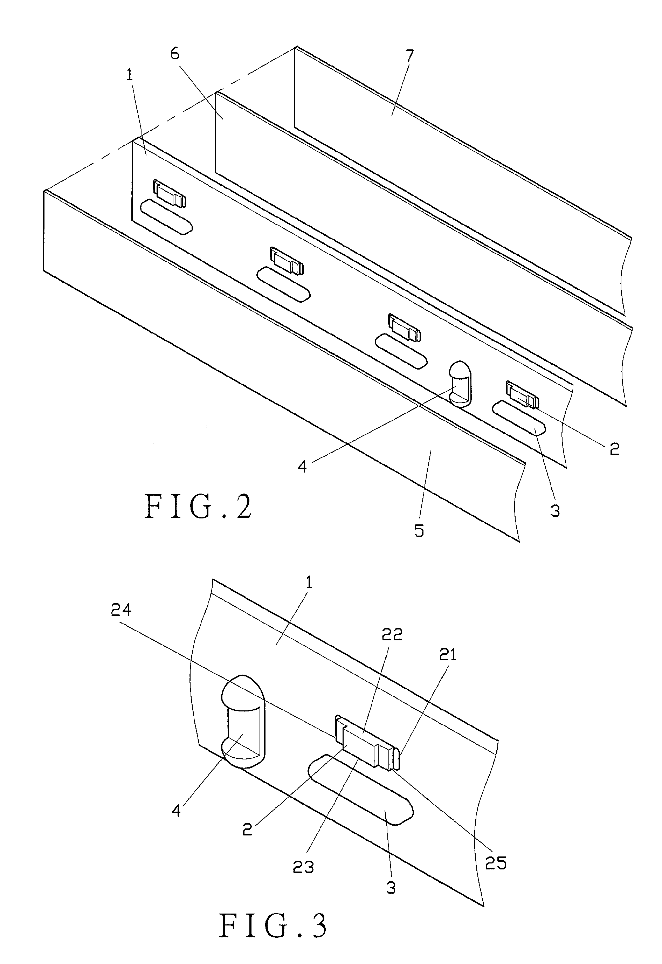

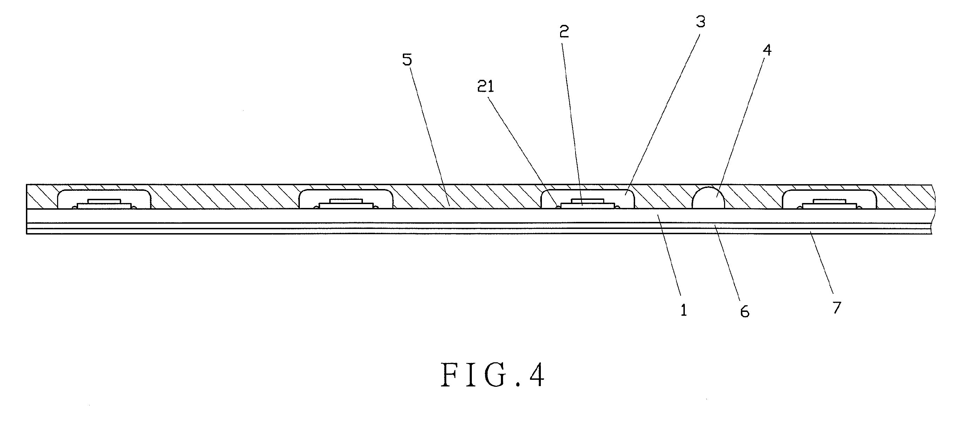

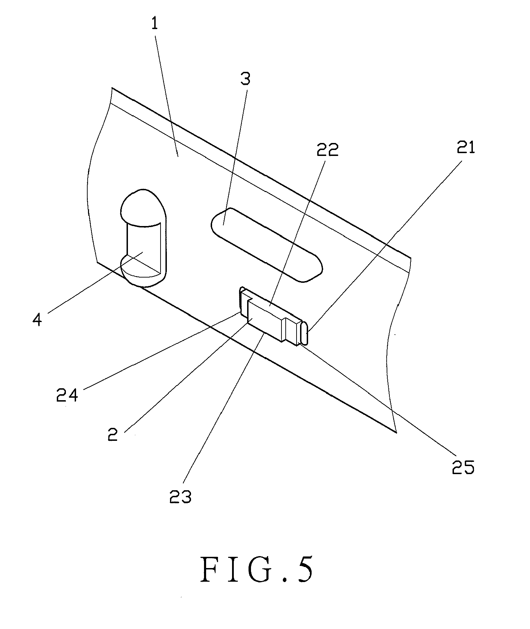

Figs. **2**, **3**, **4**, and **5** show a first preferred embodiment of the present invention. An anti-deflection structure for a flexible circuit board comprises a flexible circuit board **1**, at least one electronic element **2**, at least one anti-deflection element 3, at least one surface-mount device (SMD) **4**, a first silicone membrane 5, a second silicone membrane **6**, and a two-sided adhesive **7**.

The flexible circuit board **1** includes an outer surface, an inner portion or an inner surface. The flexible circuit board **1** adopts a printed circuit board.

The electronic element **2** is disposed on the flexible circuit board **1**. The electronic board **2** has a weld **21** soldered to the flexible circuit board 1. The electronic element **2** respectively installs a first side **22** and a second side **23** that are correspondingly disposed at intervals. The electronic **2** further installs a third side **24** and a fourth side **25** that are respectively disposed adjacent to the first side **22** and the second side **23** at intervals.

The anti-deflection element **3** is disposed on the outer surface of the flexible circuit board **1**. The anti-deflection element **3** could be alternatively disposed in the inner portion or the inner surface of the flexible circuit board **1**. The anti-deflection element **3** is further arranged around the weld **21** of the electronic element **2**. The anti-deflection element 3 is situated out of the first side **22** or the second side **23** of the electronic element **2**. Two end portions are correspondingly defined on the anti-deflection element **3** at intervals. A distance between the two end portions of the anti-deflection element **3** is larger than or equal to a distance between the third side **24** and the fourth side **25** of the electronic element **2**.

The SMD **4** is disposed on the flexible circuit board **1**. The SMD **4** is an electric resistance of a surface-mount device type.

The first silicone membrane **5** completely covers on the outer surface of the flexible circuit board **1** for preventing the water from permeating into the flexible circuit board 1.

The second silicone membrane **6** completely covers on the inner surface of the flexible circuit board **1** for preventing the water from permeating into the flexible circuit board **1**.

The two-sided adhesive **7** adheres to the second silicone membrane **6** for sticking.

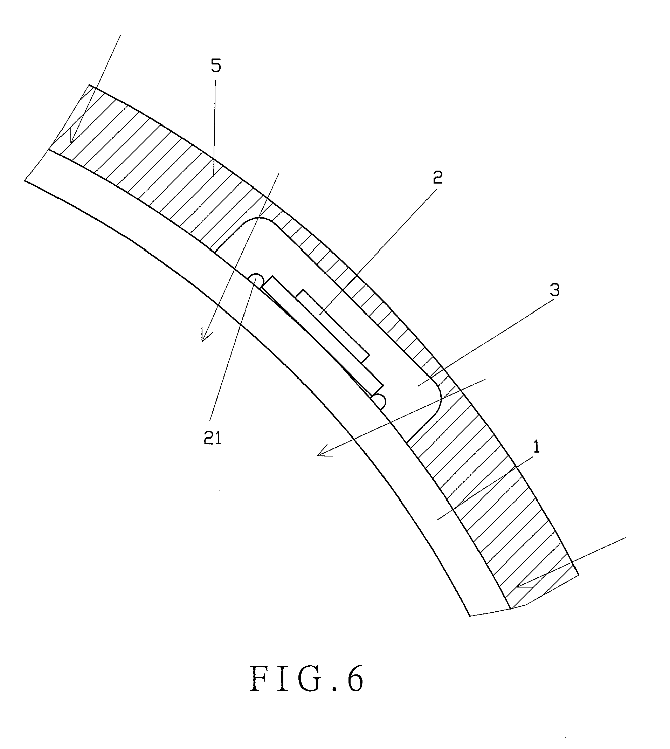

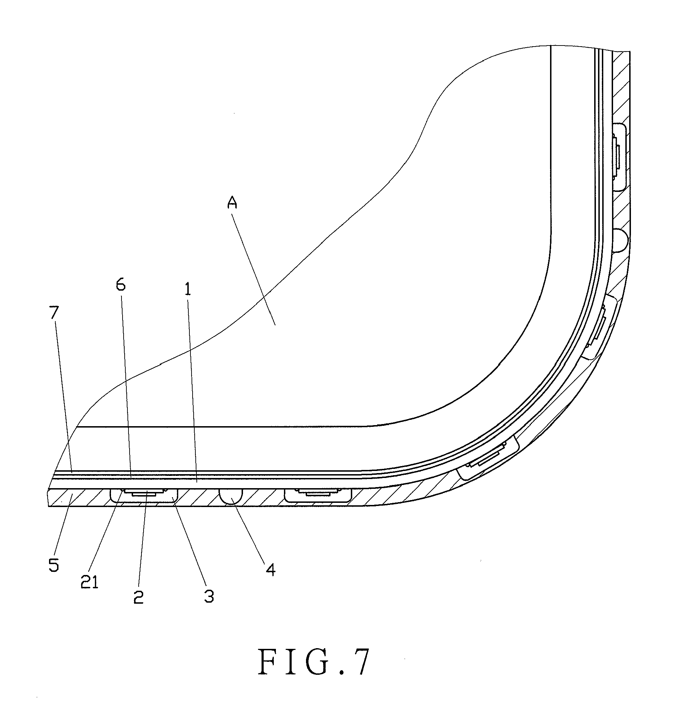

Figs. **6** and **7** show the present invention in using. The flexible circuit board **1** is stuck to a car body A or other products correlated to the car body by means of the two-sided adhesive **7** in accordance with the arc defined on the car body A or other products correlated to the car body. Stuck to the car body A with a certain arc, the flexible circuit board **1** is thence bent by an external force. Herein, the anti-deflection element **3** around the weld **21** on the electronic element **2** absorbs the external force in time of bending so as to generate a cushioning effect. Thereby, the weld **21** on the flexible circuit board **1** is prevented from directly bearing the external force in time of bending. Thus, the weld **21** does not readily break in view of the external force, and the electronic element **2** does not fall off or malfunction. Concurrently, the first silicone membrane **5** disposed on the outer surface of the flexible circuit board **1** and the second silicone membrane **6** disposed on the inner surface of the same preferably impede the water from permeating into the flexible circuit board **1**, so that the flexible circuit board **1** does not damage.

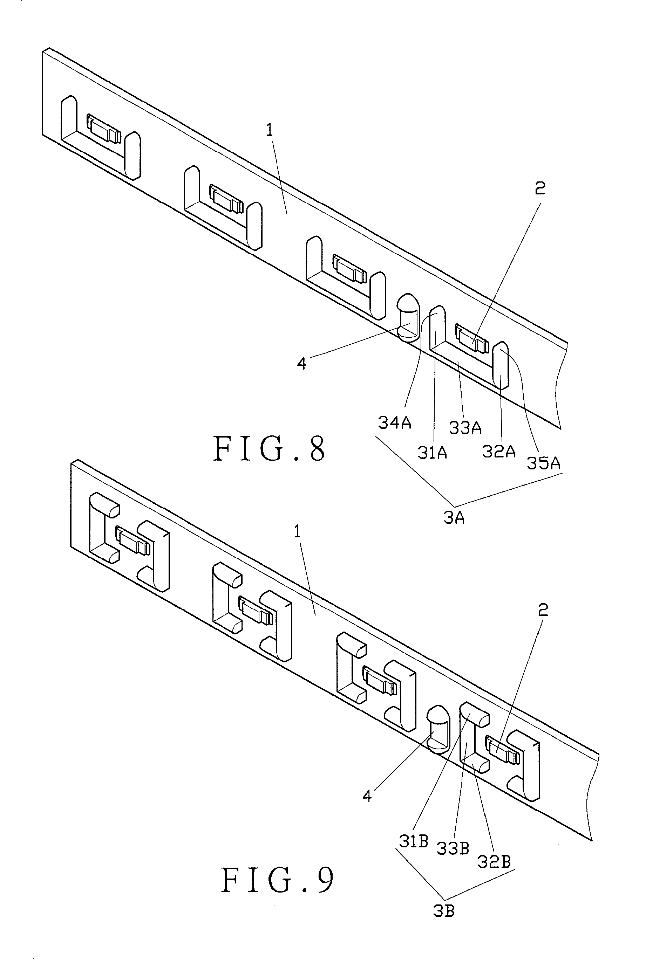

Fig. **8** shows a second preferred embodiment of the present invention. The anti-deflection element **3A** has a first perpendicular section **31A** and a second perpendicular section **32A** that are correspondingly and parallelly disposed at intervals. The anti-deflection element **3A** further has a horizontal section **33A** that is horizontally connected to the first perpendicular section **31A** and the second perpendicular section **32A**. The first perpendicular section **31A** and the second perpendicular section **32A** respectively have a first end portion **34A** and a second end portion **35A** that are spaced at intervals. The first end portion **34A** and the second end portion **35A** of the anti-deflection element 3A are respectively arranged out of the third side **24** and the fourth side **25** of the electronic element **2** as shown in Fig. **3**.

Fig. **9** shows a third preferred embodiment of the present invention. Two correspondent anti-deflection elements **3B** are disposed around the electronic element **2**. The anti-deflection element **3B** includes a first horizontal section **31B** and a second horizontal section **32B** that are correspondingly and parallelly disposed at intervals. The anti-deflection element **3B** further has a perpendicular section **33B** that is perpendicularly connected to the first horizontal section **31B** and the second horizontal section **32B**. Each anti-deflection element **3B** includes two end portions that are correspondingly disposed at intervals. The two end portions of the anti-deflection element **3B** is situated out of the third side **24** of the electronic element **2** as shown in Fig. **3**, and the two end portions of another anti-deflection element **3B** is situated out of the fourth side **25** of the electronic element 2.

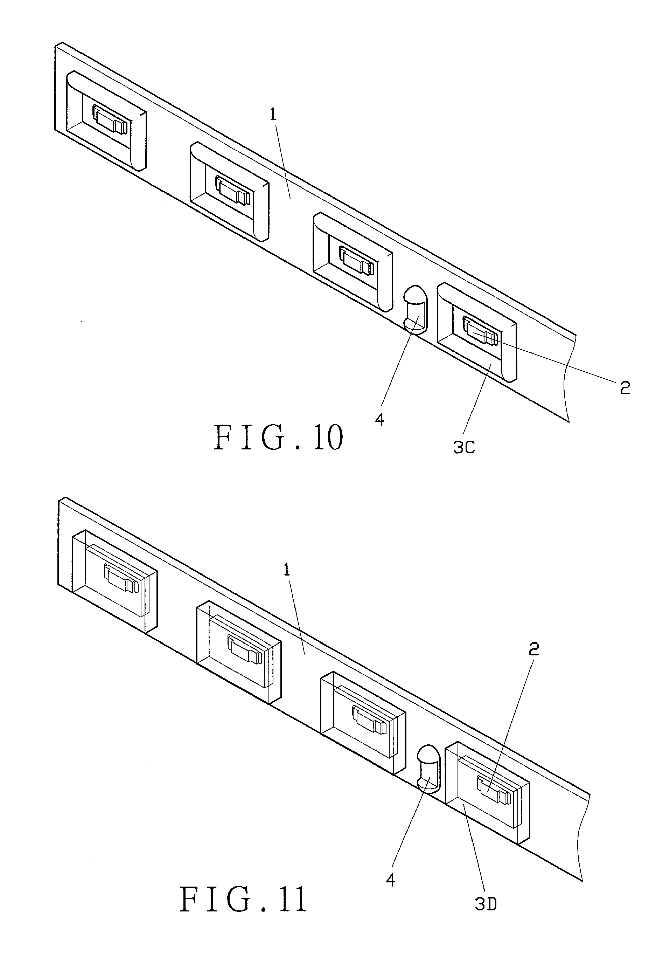

Fig. **10** shows a fourth preferred embodiment of the present invention. The anti-deflection element **3C** adopts a quadrilateral frame, and the anti-deflection element 3C is arranged around the electronic element **2**.

Fig. **11** shows a fifth preferred embodiment of the present invention. The anti-deflection element **3D** adopts a transparent housing, and the anti-deflection element **3D** covers on the electronic element **2**.

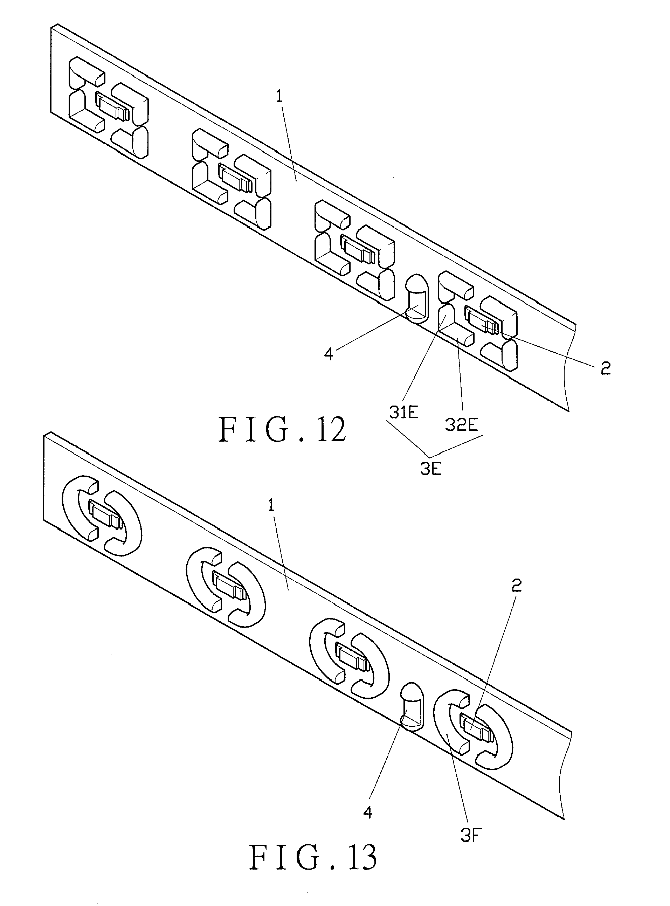

Fig. **12** shows a sixth preferred embodiment of the present invention. The anti-deflection element **3E** has a perpendicular section **31E** and a horizontal section **32E** having one end connected to the perpendicular section **31E**. Moreover, the perpendicular section **31E** and the horizontal section **32E** of the anti-deflection element **3E** are arranged around the electronic element **2**.

Fig. **13** shows a seventh preferred embodiment of the present invention. The anti-deflection element **3F** adopts a semi-arc shape, and the anti-deflection element **3F** is arranged around the electronic element **2**.

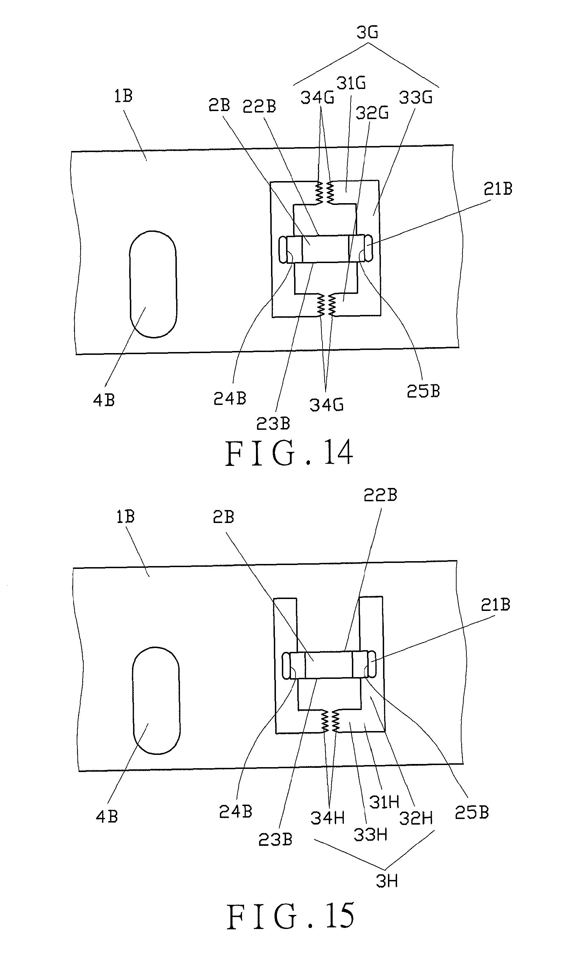

Fig. **14** shows an eighth preferred embodiment of the present invention. The electronic element **2B** has a weld **21B** soldered on the anti-deflection element **3G** that adopts a copper foil coated with tin. Such copper foil coated with tin is actually the wetting, a common tinning technique in the market. The electronic element **2B** has a first side 22B and a second side **23B** that are respectively and correspondingly disposed at intervals. The electronic element **2B** further has a third side **24B** and a fourth side **25B** that are disposed adjacent to the first side **22B** and the second side **23B** at intervals. Two correspondent anti-deflection element **3G** are disposed around the electronic element **2B**. The anti-deflection element **3G** has a first horizontal section **31G** and a second horizontal section **32G** that are correspondingly and parallelly disposed at intervals. The anti-deflection element **3G** further has a perpendicular section **33G** that is perpendicularly connected to the first horizontal section **31G** and the second horizontal section **32G**. Each anti-deflection element **3G** has two correspondent end portions that are spaced at intervals. The two end portions of the anti-deflection element **3G** is situated out of the first side **22B** and the second side **23B** of the electronic element **2B**. Another anti-deflection element **3G** is disposed corresponding to the anti-deflection element **3G**. Both two end portions of the second anti-deflection element **3G** are situated out of the first side **22B** and the second side **23B** of the electronic element **2B**. The two end portions of the anti-deflection element **3G** have at least one pointed end **34G**. By means of the electronic element **2B** being soldered on the anti-deflection element **3G** and the two end portions of the two anti-deflection elements **3G** having the pointed ends **34G** that are facing each other, the pointed end of the anti-deflection element **3G** preferably discharges electricity to prevent the surge energy generated by the overloaded current. Thus, the electronic element **2B** is not damaged.

Fig. **15** shows a ninth preferred embodiment of the present invention. The electronic element **2B** has a weld **21B** soldered on the anti-deflection element **3H**. The anti-deflection element **3H** provides a horizontal section **31H** and a perpendicular section **32H** having one end connected to the horizontal section **31H**. The horizontal section **31H** includes an end portion **33H** that is situated out of the second side **23B** of the electronic element **2B**. The other anti-deflection element **3H** is situated at a correspondent end of the former anti-deflection element **3H**. The later anti-deflection element 3H provides a horizontal section **31H** and a perpendicular section **32H** having one end connected to the horizontal section **31H**. The horizontal section **31H** includes an end portion **33H** that is situated out of the second side **23B** of the electronic element **2B**. The end portion **33H** of the anti-deflections **3H** further has at least one pointed end **34H**.

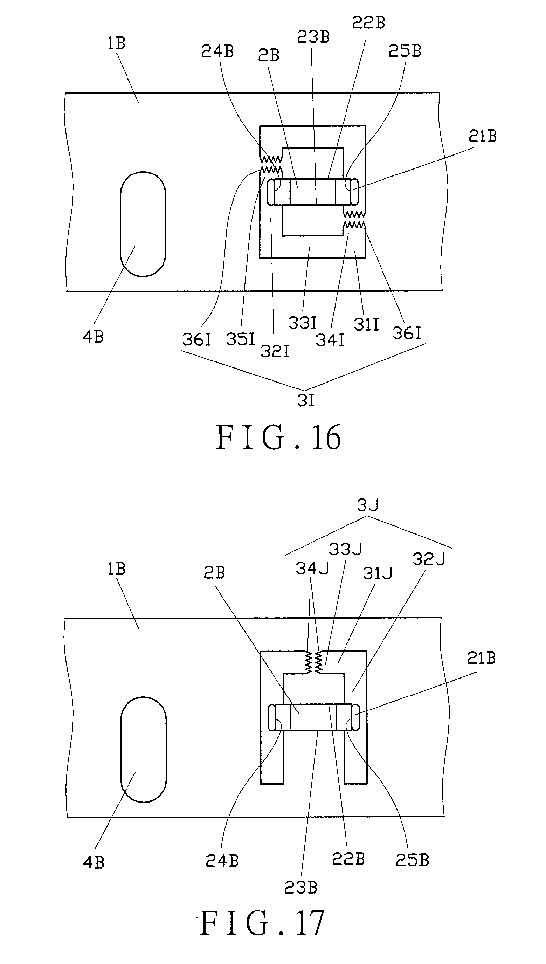

Fig. **16** shows a tenth preferred embodiment of the present invention. The electronic element **2B** provides a weld **21B** soldered on the anti-deflection element **3I**. The anti-deflection element **31** has a first perpendicular section **31I** and a second perpendicular section **321** that are correspondingly and parallelly disposed at intervals. The first perpendicular section **31I** and the second perpendicular section **32I** have their respective ends connected to a horizontal section **33I**. The first perpendicular section **31I** and the second perpendicular section **32I** have a first end portion 341 and a second end portion **35I** that are correspondingly disposed at intervals. The other anti-deflection element 31 has a first perpendicular section **31I** and a second perpendicular section **32I** that are correspondingly and parallelly disposed at intervals. The first perpendicular section **31I** and the second perpendicular section **32I** have their respective ends connected to a horizontal section **33I**. The first perpendicular section **31I** and the second perpendicular section **32I** have their first end portion **34I** and second end portion **35I** that are correspondingly disposed at intervals. The anti-deflection element **3I** is arranged around the electronic element **2B**. The first end portions **34I** and the second end portions **35I** of the anti-deflection elements **3I** have at least one pointed end **36I**.

Fig. **17** shows an eleventh preferred embodiment of the present invention. The electronic element **2B** has a weld **21B** soldered to the anti-deflection element **3J**. The anti-deflection element **3J** provides a horizontal section **31J** and a perpendicular section **32J** having one end connected to the horizontal section **31J**. The horizontal section **31J** defines an end portion **33J** that is situated out of the first side **22B** of the electronic element **2B**. The other anti-deflection element **3J** is further situated corresponding to one end of former anti-deflection element **3J**. The later anti-deflection element **3J** has a horizontal section **31J** and a perpendicular section **32J** having one end connected to the horizontal section **31J**. The horizontal section 31J includes an end portion **33J** that is situated out of the first side **22B** of the electronic element **2B**. The end portions **33J** of the anti-deflection elements **3J** have at least one pointed end **34J**.

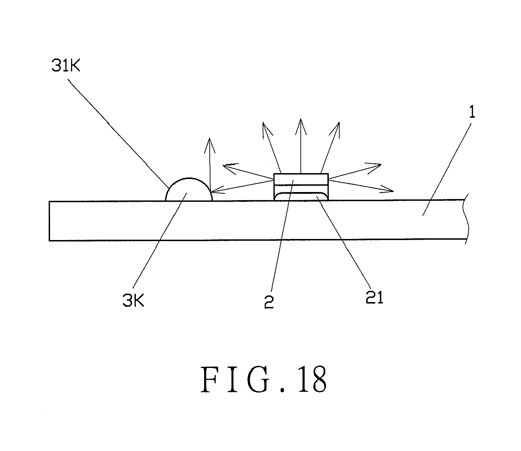

Fig. **18** shows a twelfth preferred embodiment of the present invention. The anti-deflection element **3K** has a reflecting surface **31K** that directly reflects the light emitted by the electronic element **2** when the electronic element **2** is illuminable. Thereby, the brightness on the flexible circuit board **1** is increased, and a favorable lighting effect is achieved.

Aforesaid embodiments do not limit the claimed scope of the present invention. Alike variation and alternation made in accordance with the claims and specification of the present invention do not depart from the spirit of the present invention.

## Claims

1. An anti-deflection structure for a flexible circuit board (1) comprising at least one electronic element (2) disposed on said flexible circuit board (1) via soldering by a weld (21) on said flexible circuit board (1); **characterized in that**:
said flexible circuit board (1) includes at least one anti-deflection element (3) disposed thereon; said anti-deflection element (3) is disposed around said weld (21) of said electronic element (2).

2. The anti-deflection structure as claimed in claim 1, wherein said anti-deflection element (3) adopts a copper foil coated with tin.

3. The anti-deflection structure as claimed in claim 2, wherein said electronic element (2) has a first side (22) and a second side (23) that are correspondingly and respectively disposed thereon at intervals; said electronic element (2) further has a third side (24) and a fourth side (25) that are correspondingly and respectively disposed adjacent to said first side (22) and said second side (23) at intervals; said anti-deflection element (3) is disposed out of said first side (22) or said second side (23) of said electronic element (2); said anti-deflection element (3) provides two end portions that are correspondingly disposed at intervals; a distance between said two end portions of said anti-deflection element (3) is larger than or equal to a distance between said third side (24) and said fourth side (25) of said electronic element (2).

4. The anti-deflection structure as claimed in claim 2, wherein said electronic element (2) has a first side (22) and a second side (23) that are correspondingly and respectively disposed at intervals; said electronic element (2) further has a third side (24) and a fourth side (25) that are respectively disposed adjacent to said first side (22) and said second side (23) at intervals; said anti-deflection element (3A) provides a first perpendicular section (31A) and a second perpendicular section (32A) that are correspondingly and parallelly disposed at intervals; said anti-deflection element (3A) further provides a horizontal section (33A) that is horizontally connected to said first perpendicular section (31A) and said second perpendicular section (32A); said first perpendicular section (31A) and said second perpendicular section (32A) respectively have a first end portion (34A) and a second end portion (35A) that are spaced at intervals; said first end portion (34A) of said first perpendicular section (31A) and said second end portions (35A) of said second perpendicular section (32A) are respectively disposed out of said third side (24) and said fourth side (25) of said electronic element (2).

5. The anti-deflections structure as claimed in claim 2, wherein said electronic element (2) respectively has a first side (22) and a second side (23) that are correspondingly disposed at intervals; said electronic element (2) further has a third side (24) and a fourth side (25) that are respectively disposed adjacent to said first side (22) and said second side (23) at intervals; two opposing anti-deflection elements (3B) are disposed around said electronic element (2); each said anti-deflection element (3B) provides a first horizontal section (31B) and a second horizontal section (32B) that are correspondingly and parallelly disposed at intervals; each said anti-deflection element (3B) further provides a perpendicular section (33B) that is perpendicularly connected to said first horizontal section (31B) and said second horizontal section (32B); each said anti-deflection element (3B) installs two end portions that are correspondingly disposed at intervals; said end portions of one said anti-deflection element (3B) are situated out of said third side (24) of said electronic element (2); the other anti-deflection element (3B) is situated corresponding to said anti-deflection element (3B); said end portions of the other said anti-deflection element (3B) are situated out of said fourth side (25) of said electronic element (2).

6. The anti-deflection structure as claimed in claim 2, wherein said electronic element (2B) has a first side (22B) and a second side (23B) that are correspondingly and respectively disposed thereon at intervals; said electronic element (2B) further has a third side (24B) and a fourth side (25B) that are correspondingly and respectively disposed adjacent to said first side (22B) and said second side (23B) at intervals; two opposing anti-deflection elements (3G) are disposed around said electronic element (2B); each said anti-deflection element (3G) has a first horizontal section (31G) and a second horizontal section (32G) that are correspondingly and parallelly disposed at intervals; each said anti-deflection element (3G) further have a perpendicular section (33G) that is perpendicularly connected to said first horizontal section (31G) and said second horizontal section (32G); each said anti-deflection element (3G) provides two end portions that are correspondingly disposed at intervals; said end portions of said anti-deflection element (3G) is situated out of said first side (22B) and said second side (23B) of said electronic element (2B); the other anti-deflection element (3G) is situated corresponding to said anti-deflection element (3G); said end portions of the other said anti-deflection element (3G) are situated out of said first side (22B) and said second side (23B) of said electronic element (2B); said end portions of said anti-deflection elements (3G) provide at least one pointed end (34G).

7. The anti-deflection structure as claimed in claim 2, wherein said electronic element (2B) respectively has a first side (22B) and a second side (23B) that are correspondingly disposed at intervals; said electronic element (2B) further has a third side (24B) and a fourth side (25B) that are respectively disposed adjacent to said first side (22B) and said second side (23B) at intervals; said anti-deflection element (3H) provides a horizontal section (31H) and a perpendicular section (32H) having one end connected to said first horizontal section (31H); said horizontal section (31H) has an end portion (33H) that is positioned out of said second side (23B) of said electronic element (2B); another anti-deflection element (3H) is disposed corresponding to said former anti-deflection element (3H); said anti-deflection element (3H) provides a horizontal section (31H) and a perpendicular section (32H) having one end connected to said horizontal section (31H); said horizontal section (31H) includes an end portion (33H) that is positioned out of said second side (23B) of said electronic element (2B); one of said end portions (33H) of said anti-deflection elements (3H) has at least one pointed end (34H).

8. The anti-deflection structure as claimed in claim 2, wherein said electronic element (2B) has a first side (22B) and a second side (23B) that are correspondingly and respectively disposed at intervals; said electronic element (2B) further has a third side (24B) and a fourth side (25B) that are respectively disposed adjacent to said first side (22B) and said second side (23B) at intervals; said anti-deflection element (3I) provides a first perpendicular section (31I) and a second perpendicular section (32I) that are correspondingly and parallelly disposed at intervals; said first perpendicular section (31I) and said second perpendicular section (321) have their ends connected to a horizontal section (331); said first perpendicular section (31I) and said second perpendicular section (321) correspondingly provide a first end portion (341) and a second end portion (351) that are spaced at intervals; another anti-deflection element (31) correspondingly provides a first perpendicular section (31I) and a second perpendicular section (321) that are parallelly disposed at intervals; said first perpendicular section (31I) and said second perpendicular section (321) have their ends connected to a horizontal section (331); said first perpendicular section (31I) and said second perpendicular section (321) correspondingly provide a first end portion (341) and a second end portion (351) that are spaced at intervals; said anti-deflection elements (31) are disposed around said electronic element (2B); said first end portion (341) and said second end portion (351) of said anti-deflection elements (31) provide at least one pointed end (36I).

9. The anti-deflection structure as claimed in claim 2, wherein said electronic element (2B) has a first side (22B) and a second side (23B) that are correspondingly and respectively disposed at intervals; said electronic element (2B) further has a third side (24B) and a fourth side (25B) that are respectively disposed adjacent to said first side (22B) and said second side (23B) at intervals; said anti-deflection element(3J) provides a horizontal section (31J) and a perpendicular section (32J) having one end connected to said horizontal section (31J); said horizontal section (31J) has an end portion (33J) that is positioned out of said first side (22B) of said electronic element (2B); another anti-deflection element (3J) is disposed corresponding to said former anti-deflection element (3J); said anti-deflection element (3J) provides a horizontal section (31J) and a perpendicular section (32J) having one end connected to said horizontal section (31J); said horizontal section (31J)includes an end portion (33J) that is positioned out of said first side (22B) of said electronic element(2B); one of said end portions (33J) of said anti-deflection elements (3J) has at least one pointed end (34J).

10. The anti-deflection structure as claimed in claim 2, wherein at least one surface-mount device (SMD) (4) is disposed on said flexible circuit board (1), adjacent to said electronic element (2).

11. The anti-deflection structure as claimed in claim 2, wherein said anti-deflection element (3K) has a reflecting surface (31K).
